# EUROPÄISCHE PATENTANMELDUNG

(11) **EP 4 429 115 A1**
(43) Veröffentlichungstag der Anmeldung: **11.09.2024**
(21) Anmeldenummer: 23160762.3
(22) Anmeldetag: 08.03.2023
(51) Int. Cl.: H03K 17/968

(54) **BEDIENELEMENT MIT SENDER-EMPFÄNGER BASIERTER BETÄTIGUNGSDETEKTION UND FUNKTIONSÜBERWACHUNG, ZUGEHÖRIGES VERFAHREN UND VERWENDUNG**

(71) Anmelder: Preh GmbH, 97616 Bad Neustadt a.d. Saale (DE)
(72) Erfinder: Bodenstein, Tobias, 97616 Salz (DE); Gaspar, Zoltan, 500002 Brasov (RO)
(74) Vertreter: Lohmanns, Bernard

(57) **Zusammenfassung**

Die Erfindung betrifft einen Bedienelement (1), aufweisend einen Träger (2); ein am Träger (2) elastisch rückstellend und beweglich gelagertes und/oder am Träger (2) elastisch verformbar abgestütztes Betätigungsteil (3), welches eine einem Bediener (B) zugewandte Betätigungsfläche (10) aufweist, und um eine Verlagerung (X) der Betätigungsfläche (10) entgegen einer Rückstellkraft relativ zum Träger (2) bei Einwirken einer Betätigungskraft auf die Betätigungsfläche (10) zu ermöglichen; eine Detektionseinrichtung (4) zur Detektion der Verlagerung (X), die einen Sender (4a) und einen Empfänger (4b) aufweist, wobei der Sender (4a) ein am Empfänger (4b) anliegendes, mit der Verlagerung (X) variierendes Eingangssignal (I) erzeugt, wobei der Empfänger (4b) aus dem Eingangssignal (I) ein Ausgangssignal (O) erzeugt, wobei das Eingangssignal (I) ferner durch einen von der Verlagerung (X) unabhängigen, weiteren Parameter (R) variiert werden kann, wobei zumindest über einen Arbeitsbereich (A) des Ausgangssignals (O) bei konstantem weiteren Parameter (R) dem Ausgangssignal (O) eine Verlagerung (X) eindeutig zugeordnet werden kann; eine Auswerteinheit (5), die ausgebildet ist, in einer Detektionsphase bei einem im Wesentlichen konstanten Wert des weiteren Parameters (R) aus dem im Arbeitsbereich (A) liegenden Ausgangssignal (O) die Verlagerung (X) zu ermitteln und in wenigstens einer Testphase, bei der Wert des weiteren Parameters (R) gegenüber dem konstanten Wert so verändert ist oder wird, dass das Eingangssignal (I) der Testphase in einem außerhalb des Arbeitsbereichs (A) liegenden Ausgangssignal (O) resultiert, das resultierende Ausgangssignal (O) dahingehend auszuwerten, ob die Funktion des Senders (4a) und/oder die Funktion des Empfängers (4b) gewährleistet ist.

## Beschreibung

Die Erfindung betrifft ein Bedienelement mit Sender-Empfänger basierter Betätigungsdetektion. Bedienelemente, die zur Steuerung sicherheitsrelevanter Fahrzeugfunktion vorgesehen sind, insbesondere wenn das Fahrzeug ausgebildet ist, in einer der unterschiedlichen Automatisierungsstufen autonom zu fahren, unterliegen hohen Sicherheitsanforderungen. Teilweise wird dies durch Maßnahmen zur gesteigerten Störunanfälligkeit des Bedienelements bis hin zur redundanten Auslegung des Bedienelements gelöst. Dazu gehört, dass die Betätigungsdetektion meist berührungslos durchgeführt wird, wobei eine optische Detektion einer kapazitiven Detektion meist bevorzugt wird, da letztere oft empfindlich auf elektromagnetische Einstreuung reagiert. Optische Detektionseinrichtungen basieren im Prinzip darauf, dass die Verlagerung mit einer Lichtintensitätsveränderung einhergeht, welche als optisches Eingangssignal auf einen optischen Sensor als Empfänger trifft und von diesem detektiert wird. Die durch die Betätigung bewirkte Lichtintensitätsveränderung ergibt sich beispielsweise durch eine Veränderung der optischen Weglänge zwischen Sensor und Lichtquelle und/oder eine Veränderung der Ausrichtung von Sensor und/oder Lichtquelle, da das Abstrahlverhalten (Sendecharakteristik) der Lichtquelle und die Empfangscharakteristik des Sensors in der Regel richtungsabhängig sind. Bei einer quantitativen, also letztlich die Betätigungskraft ermittelnden aber selbst bei einer qualitativen Erfassung der Verlagerung kommt es insbesondere bei einem geringen Hub der sich zwischen Ruhestellung und gedrückter Stellung bei der Betätigung verlagernden Betätigungsfläche auf die Erfassung kleinster Lichtintensitätsschwankungen an, so dass die Messempfindlichkeit hoch ist und daher eine Funktionsüberwachung anspruchsvoll ist.

Der Erfindung liegt daher die Aufgabe zugrunde, ein Bedienelement, insbesondere für ein Kraftfahrzeug, bereitzustellen, bei dem eine Funktionsüberwachung von Sender und/oder Empfänger realisiert ist. Erfindungsgemäß wird die Aufgabe durch ein Bedienelement mit den Merkmalen des Anspruchs 1 gelöst. Eine gleichermaßen vorteilhafte Verwendung sowie ein Verfahren zur Funktionsüberwachung sind jeweils Gegenstand der nebengeordneten Ansprüche. Es ist darauf hinzuweisen, dass die in der nachfolgenden Beschreibung einzeln aufgeführten Merkmale sowie Maßnahmen in beliebiger, technisch sinnvoller Weise miteinander kombiniert werden können und weitere Ausgestaltungen der Erfindung aufzeigen. Die Beschreibung charakterisiert und spezifiziert die Erfindung insbesondere im Zusammenhang mit den Figuren zusätzlich.

Das Bedienelement weist einen Träger auf. Der Träger dient beispielsweise der Festlegung an einer tragenden Fahrzeugkomponente, beispielsweise an einem Lenkradkörper, einer Fahrzeuginnenraumverkleidung, einem Fahrzeugrahmen oder einem Armaturenbrett. Erfindungsgemäß ist ein am Träger elastisch rückstellend und beweglich gelagertes und/oder am Träger elastisch verformbar abgestütztes Betätigungsteil vorgesehen, welches eine einem Bediener, beispielsweise Fahrzeuginsassen, insbesondere Fahrzeuglenker, zugewandte Betätigungsfläche aufweist. Erfindungsgemäß ist eine Verlagerung der Betätigungsfläche entgegen einer Rückstellkraft relativ zum Träger bei Einwirken einer Betätigungskraft auf die Betätigungsfläche ermöglicht. Beispielsweise wird eine elastische Rückstellung der Betätigungsfläche durch ein elastisches Zusammenwirken von Betätigungsteil und Träger über ein oder mehrere Federelemente, beispielsweise aus Federstahl oder Elastomer, erreicht und/oder durch eine zumindest bereichsweise elastische Verformbarkeit des Betätigungsteils selbst.

Erfindungsgemäß ist eine Detektionseinrichtung zur Detektion der Verlagerung vorgesehen. Die Detektionseinrichtung weist einen Sender und einen Empfänger auf, wobei der Sender ein am Empfänger anliegendes, mit der Verlagerung variierendes Eingangssignal erzeugt. Der zugehörige Empfänger wiederum erzeugt aus dem Eingangssignal ein Ausgangssignal. Das Eingangssignal kann durch einen von der Verlagerung unabhängigen, weiteren Parameter variiert werden. Über einen Arbeitsbereich als spezifische Variationsbreite des Ausgangssignals kann bei konstantem weiterem Parameter dem Ausgangssignal eine Verlagerung eindeutig zugeordnet werden.

Bevorzugt handelt es sich um eine optische Detektionseinrichtung mit einer Lichtquelle als Sender und einer Fotodiode als Empfänger. Eingangssignal ist beispielsweise die auf die lichtempfindliche Fläche der Fotodiode bezogene Lichtintensität. Der Parameter ist beispielsweise die von der Lichtquelle erzeugte Lichtstärke. Durch Veränderung der Lichtstärke der Lichtquelle ist die auf die lichtempfindliche Fläche der Fotodiode bezogene Lichtintensität unabhängig von der Verlagerung aber zusätzlich zur Verlagerung variierbar.

Erfindungsgemäß weist das Bedienelement ferner eine Auswerteinheit auf, die ausgebildet ist, in einer Detektionsphase aus dem im Arbeitsbereich liegenden Ausgangssignal die Verlagerung mehrfach zu ermitteln, wobei der weitere Parameter einen im Wesentlichen konstanten Wert einnimmt.

Erfindungsgemäß ist wenigstens eine Testphase vorgesehen, bei der der Wert des weiteren Parameters gegenüber dem konstanten Wert so verändert ist oder wird, dass das Eingangssignal der Testphase in einem außerhalb des Arbeitsbereichs liegenden Ausgangssignal resultiert und die Auswerteinheit ausgebildet ist, das resultierende Ausgangssignal dahingehend auszuwerten, ob die Funktion des Senders und/oder die Funktion des Empfängers gewährleistet ist. Beispielsweise wird das Ausgangsignal mit einem zu erwartenden vorgespeicherten Vergleichswert verglichen und bei Überschreiten einer vorgegebenen Maximalabweichung, eine Fehlfunktion des Senders und/oder Empfängers an eine übergeordnete Steuereinheit gemeldet, welche in Folge beispielsweise den autonomen Fahrbetrieb unterbricht oder verweigert.

Bevorzugt ist die Auswerteinheit ausgelegt, erst nach einer Fehlertoleranzdauer auf ein dem Arbeitsbereich nicht zuordenbares Ausgangssignal mit einer Fehlerausgabe oder einem Fehlerzustand zu reagieren, und die Testphase in die Fehlertoleranzdauer fällt. Dadurch ist es nicht erforderlich, die Detektionsphase für die Testphase zu unterbrechen und letztere kann in eine fortlaufende Detektion integriert werden, ohne dass es lediglich aufgrund eines außerhalb des Arbeitsbereichs liegenden Ausgangssignals zu einer Störung kommt. Bevorzugt beträgt die Fehlertoleranzdauer 10ms oder weniger, bevorzugter 5ms oder weniger.

Bevorzugt wird in der Testphase durch geeignete Wahl des weiteren Parameters das zugehörige Eingangssignal so eingestellt, dass eine ausschließlich durch die Verlagerung bewirkte Variation des zugehörigen Ausgangssignals geringer ausfällt als die Breite des Arbeitsbereichs, wodurch die Verlagerung geringere Auswirkung auf die Funktionsüberprüfung in der Testphase hat. Beispielsweise wird das Eingangssignal so eingestellt, dass der Empfänger in einer "Anlaufphase" arbeitet, in der das Ausgangssignal dem Eingangssignal unterproportional folgt.

Bevorzugt ist der weitere Parameter in der Testphase so gewählt, dass das zugehörige Eingangssignal den Empfänger in der Testphase zumindest zeitweise übersteuert. Dadurch kann die Zuverlässigkeit der Funktionsüberprüfung gewährleistet werden. Ferner kann das charakteristische Verhalten des Empfängers in dessen "Sättigungsbetrieb" zur Funktionsüberprüfung herangezogen werden.

Bevorzugt wird der weitere Parameter in der Testphase zeitlich variiert, wobei die Auswerteinheit ausgelegt ist, anhand des der zeitlichen Variation des weiteren Parameters folgenden Variation des Ausgangssignals die Funktion des Senders und/oder die Funktion des Empfängers zu überprüfen. Beispielsweise wird die der charakteristischen zeitlichen Variation des Parameters innerhalb vorgegebener Toleranzgrenzen folgende zeitliche Variation im Ausgangssignal als Betätigung der Funktion von Sender und Empfänger herangezogen.

Bevorzugt sind mehrere Testphasen vorgesehen, die sich im Wert des jeweiligen weiteren Parameters unterscheiden, um dadurch die Zuverlässigkeit der Funktionsüberprüfung zu steigern.

Bevorzugt ist vorgesehen, dass der oder die weiteren Parameter so gewählt sind, dass eine in der Testphase maximal mögliche, durch die Verlagerung bewirkte Variation des Ausgangssignals jeweils einen Testbereich definiert, der sich nicht mit dem Arbeitsbereich überschneidet. Bevorzugter ist vorgesehen, dass die ausschließlich durch die Verlagerung der Betätigungsfläche bewirkte, maximal mögliche Variation des Ausgangssignals den Testbereich definiert, der sich nicht mit dem Arbeitsbereich überschneidet.

Bevorzugt sind zwei Testbereiche vorgesehen, wobei der Arbeitsbereich dazwischen liegt.

Bevorzugt wird die Testphase oder werden die Tastphasen periodisch wiederholt. Arbeitsbereich zwischen zwei Testbereichen liegt.

Die Erfindung betrifft ferner Verwendung des Bedienelements in einer der zuvor beschriebenen Ausführungsformen in einem Kraftfahrzeug, insbesondere als ein am Lenkrad angeordnetes Bedienelement, beispielsweise zur Vornahme einer beim autonomen Fahren sicherheitsrelevanten Bedieneingabe.

Die Erfindung betrifft ferner ein Verfahren zur Funktionsüberprüfung eines Bedienelements, mit den folgenden Schritten. In einem Bereitstellungsschritt erfolgt ein Bereitstellen eines Bedienelements, welches einen Träger aufweist. Der Träger dient beispielsweise der Festlegung an einer tragenden Fahrzeugkomponente, beispielsweise an einem Lenkradkörper, einer Fahrzeuginnenraumverkleidung, einem Fahrzeugrahmen oder einem Armaturenbrett. Erfindungsgemäß ist ein am Träger elastisch rückstellend und beweglich gelagertes und/oder am Träger elastisch verformbar abgestütztes Betätigungsteil vorgesehen, welches eine einem Bediener, beispielsweise Fahrzeuginsassen, insbesondere Fahrzeuglenker, zugewandte Betätigungsfläche aufweist. Erfindungsgemäß wird zumindest eine Verlagerung der Betätigungsfläche entgegen einer Rückstellkraft relativ zum Träger bei Einwirken einer Betätigungskraft auf die Betätigungsfläche ermöglicht. Beispielsweise wird eine elastische Rückstellung der Betätigungsfläche durch ein elastisches Zusammenwirken von Betätigungsteil und Träger über ein oder mehrere Federelemente, beispielsweise aus Federstahl oder Elastomer, erreicht und/oder durch eine zumindest bereichsweise elastische Verformbarkeit des Betätigungsteils selbst.

Erfindungsgemäß weist das bereitgestellte Bedienelement eine Detektionseinrichtung zur Detektion der Verlagerung auf. Die Detektionseinrichtung weist einen Sender und einen Empfänger auf, wobei der Sender ein am Empfänger anliegendes, mit der Verlagerung variierendes Eingangssignal erzeugt. Der zugehörige Empfänger wiederum erzeugt aus dem Eingangssignal ein Ausgangssignal. Das Eingangssignal kann durch einen von der Verlagerung unabhängigen, weiteren Parameter variiert werden. Über einen Arbeitsbereich als spezifische Variationsbreite des Ausgangssignals kann bei konstantem weiterem Parameter dem Ausgangssignal eine Verlagerung eindeutig zugeordnet werden.

Bevorzugt handelt es sich um eine optische Detektionseinrichtung mit einer Lichtquelle als Sender und einer Fotodiode als Empfänger. Eingangssignal ist beispielsweise die auf die lichtempfindliche Fläche der Fotodiode bezogene Lichtintensität. Der Parameter ist beispielsweise die von der Lichtquelle erzeugte Lichtstärke. Durch Veränderung der Lichtstärke der Lichtquelle ist die auf die lichtempfindliche Fläche der Fotodiode bezogene Lichtintensität unabhängig von der Verlagerung aber zusätzlich zur Verlagerung variierbar. Erfindungsgemäß weist das bereitgestellte Bedienelement ferner eine Auswerteinheit auf.

Erfindungsgemäß wird eine Detektionsphase durchgeführt, um aus dem im Arbeitsbereich liegenden Ausgangssignal die Verlagerung mehrfach zu ermitteln, wobei der weitere Parameter einen im Wesentlichen konstanten Wert einnimmt.

Erfindungsgemäß wird wenigstens eine Testphase durchgeführt, bei der der weitere Parameter gegenüber dem konstanten Wert so verändert ist oder wird, dass das Eingangssignal der Testphase in einem außerhalb des Arbeitsbereichs liegenden Ausgangssignal resultiert und das resultierende Ausgangssignal durch die Auswerteinheit dahingehend ausgewertet wird, ob die Funktion des Senders und/oder die Funktion des Empfängers gewährleistet ist. Beispielsweise wird die Ausgangsignal mit einem zu erwartenden vorgespeicherten Vergleichswert verglichen und bei Überschreiten einer vorgegebenen Maximalabweichung, eine Fehlfunktion des Senders und/oder Empfängers an eine übergeordnete Steuereinheit gemeldet, welche in Folge beispielsweise den autonomen Fahrbetrieb unterbricht oder verweigert.

Gemäß einer bevorzugten Ausgestaltung des Verfahrens ist die Auswerteinheit ausgelegt, erst nach einer Fehlertoleranzdauer auf ein dem Arbeitsbereich nicht zuordenbares Ausgangssignal mit einer Fehlerausgabe oder einem Fehlerzustand zu reagieren, und die Testphase in die Fehlertoleranzdauer fällt. Dadurch ist es nicht erforderlich, die Detektionsphase für die Testphase zu unterbrechen und letztere kann in eine fortlaufende Detektion integriert werden, ohne dass es lediglich aufgrund eines außerhalb des Arbeitsbereichs liegenden Ausgangssignals zu einer Störung kommt. Bevorzugt beträgt die Fehlertoleranzdauer 10ms oder weniger, bevorzugter 5ms oder weniger.

Bevorzugt wird in der Testphase durch geeignete Wahl des weiteren Parameters das zugehörige Eingangssignal so eingestellt, dass eine ausschließlich durch die Verlagerung bewirkte Variation des zugehörigen Ausgangssignals geringer ausfällt als eine Breite des Arbeitsbereichs, wodurch die Verlagerung geringere Auswirkung auf die Funktionsüberprüfung in der Testphase hat. Beispielsweise wird das Eingangssignal so eingestellt, dass der Empfänger in einer "Anlaufphase" arbeitet, in der das Ausgangssignal dem Eingangssignal unterproportional folgt.

Bevorzugt ist der weitere Parameter in der Testphase so gewählt, dass das zugehörige Eingangssignal den Empfänger in der Testphase zumindest zeitweise übersteuert. Dadurch kann die Zuverlässigkeit der Funktionsüberprüfung gewährleistet werden. Ferner kann das charakteristische Verhalten des Empfängers in dessen "Sättigungsbetrieb" zur Funktionsüberprüfung herangezogen werden.

Bevorzugt wird der weitere Parameter in der Testphase zeitlich variiert, wobei die Auswerteinheit ausgelegt ist, anhand des der zeitlichen Variation des weiteren Parameters folgenden Variation des Ausgangssignals die Funktion des Senders und/oder die Funktion des Empfängers zu überprüfen. Beispielsweise wird die der charakteristischen zeitlichen Variation des Parameters innerhalb vorgegebener Toleranzgrenzen folgende zeitliche Variation im Ausgangssignal als Betätigung der Funktion von Sender und Empfänger herangezogen.

Bevorzugt sind mehrere Testphasen vorgesehen, die sich im Wert des jeweiligen weiteren Parameters unterscheiden, um dadurch die Zuverlässigkeit der Funktionsüberprüfung zu steigern.

Bevorzugt ist vorgesehen, dass der oder die weiteren Parameter so gewählt sind, dass eine in der Testphase maximal mögliche, durch die Verlagerung bewirkte Variation des Ausgangssignals jeweils einen Testbereich definiert, der sich nicht mit dem Arbeitsbereich überschneidet. Bevorzugter ist vorgesehen, dass eine ausschließlich durch die Verlagerung der Betätigungsfläche bewirkte, maximal mögliche Variation des Ausgangssignals den Testbereich definiert, der sich nicht mit dem Arbeitsbereich überschneidet.

Bevorzugt sind zwei Testbereiche vorgesehen, wobei der Arbeitsbereich dazwischen liegt.

Bevorzugt wird die Testphase oder werden die Tastphasen periodisch wiederholt.

Die Erfindung sowie das technische Umfeld werden nachfolgend anhand der Figuren näher erläutert. Es ist darauf hinzuweisen, dass die Figuren eine besonders bevorzugte Ausführungsvariante der Erfindung zeigen, die Erfindung jedoch nicht darauf beschränkt ist. Es zeigen:
- Fig. 1: eine schematische Ansicht einer Ausführungsform des erfindungsgemäßen Bedienelements 1;
- Fig. 2: eine Funktionsdarstellung betreffend die Zuordnung zwischen Eingangssignal I und Ausgangssignal O; der in Figur 1 gezeigten Ausführungsform des erfindungsgemäßen Fahrzeuglenkrades 1;
- Fig. 3: eine zeitliches Ablaufdiagramm der Detektionsphase und der Testphasen mit zugehörigen Eingangssignalen.

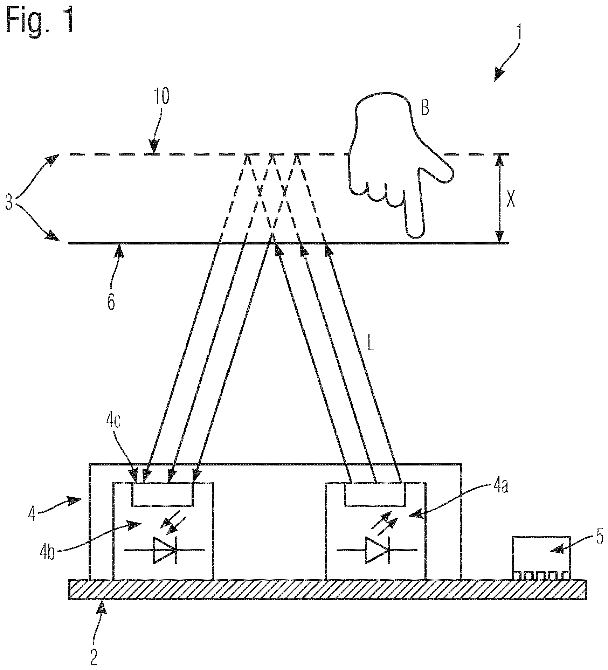

Figur 1 zeigt eine Ausführungsform des erfindungsgemäßen Bedienelements 1 in schematischer Schnittansicht. Dieses weist einen am nicht dargestellten Kraftfahrzeug festzulegenden Träger 2 auf. Wie dargestellt umfasst der Träger 2 eine Leiterplatte, auf der eine optische Detektionseinrichtung 4 und eine Auswerteinheit 5 angeordnet ist. Am Träger 2 ist ein Betätigungsteil (3) mittels nicht dargestellter Lagermittel aus einer durch die gestrichelte Linie angedeutete Ruhestellung in eine durch die durchgezogene Linie angedeutete Betätigungsstellung entgegen einer Rückstellkraft elastisch rückstellend und beweglich gelagert. Die Verlagerung X, auch als Hub bezeichnet, wird durch eine händische Einwirkung eines Bedieners B auf die Betätigungsfläche 10 des Betätigungsteils 3 bewirkt. Auf der dem Bediener B abgewandten Rückseite 6 des Betätigungsteils 3 weist eine Reflexionsschicht auf, die mit dem Licht L, hier Infrarotlicht, der optischen Detektionseinrichtung 4 zusammenwirkt. Diese umfasst eine Leuchtdiode als Sender 4a und eine Fotodiode als Empfänger 4b. Das Licht L des Senders 4a ist auf die Rückfläche 6 des Betätigungsteils 3 gerichtet, wird dort in Richtung des Empfängers 4b, insbesondere auf dessen lichtempfindliche Fläche 4c, reflektiert, wobei das auf die lichtempfindliche Fläche 4c fallende Licht L, insbesondere die auf die lichtempfindliche Fläche 4c bezogene Lichtintensität als Eingangssignal I betrachtet wird. Das Eingangssignal I variiert mit der Verlagerung X, was im Wesentlichen auf der durch die Verlagerung X bewirkten Veränderung der optischen Weglänge zwischen Sender 4a und Empfänger 4b beruht. Das Eingangssignal I wird durch den Empfänger 4b in ein elektrisches Ausgangssignal O umgewandelt, das an die Auswerteinheit 5 übermittelt wird. Diese ermittelt aus dem Ausgangssignal O die Verlagerung X, um beispielsweise dem Maß der Verlagerung einen proportionalen Steuerwert zuzuordnen oder bei Unterschreiten oder Überschreiten eines vorgegebenen Vorgabewerts eine Schaltzustandsveränderung einer zugeordneten Schaltfunktionalität zu erwirken. Das in Figur 1 gezeigte Bedienelement 1 ist beispielsweise an einem Lenkrad eines Kraftfahrzeugs, insbesondere zur Steuerung einer in einem autonomen Fahrbetriebs sicherheitsrelevanten Betriebsfunktion des Kraftfahrzeugs vorgesehen. Daher umfasst die erfindungsgemäß vorgesehene Detektionsphase zur Ermittlung der Verlagerung X mehrere Testphasen, in denen die Funktionsfähigkeit von Sender 4a und/oder Empfänger 4b einer Funktionsüberprüfung unterzogen werden, wie nachfolgend erläutert wird.

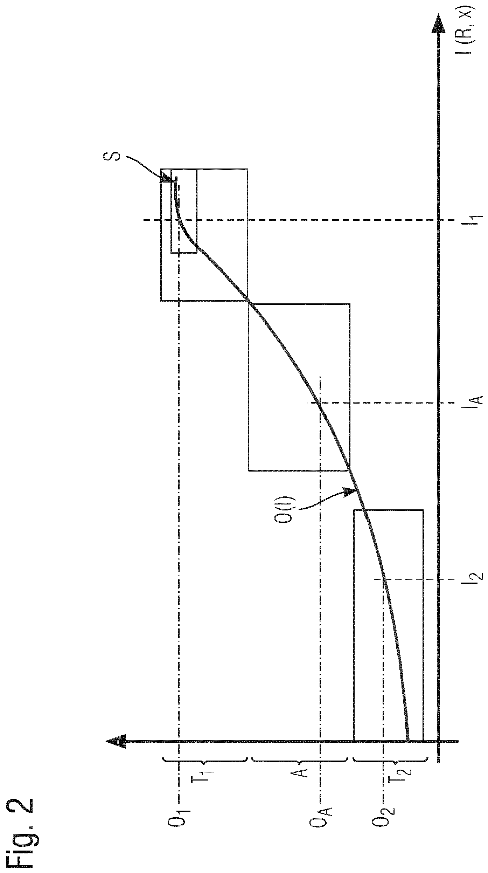

Figur 2 zeigt die Zuordnung zwischen Eingangssignal I und Ausgangssignal O. Das Eingangssignal I variiert in Abhängigkeit der Verlagerung X aber auch in Abhängigkeit eines weiteren Parameters, beispielsweise der voreingestellten Lichtstärke des Senders 4a, der nicht an die Verlagerung X gekoppelt ist. Die Zuordnung zwischen Eingangssignal I und Ausgangssignal O ergibt sich aus dem Verlauf des Graphen O(I), die hier einen stetig steigenden Verlauf zeigt und sich ausgehend vom Ursprung über einen Anlaufbereich des Ausgangssignals, der hier als zweiter Testbereich T₂ des Ausgangssignal O bezeichnet wird, einen nachfolgenden Arbeitsbereich A bis in einen Auslaufbereich, der hier als erster Testbereich T₁ des Ausgangssignal O bezeichnet wird. Letzterer umfasst den Sättigungsbereich S, bei dem das zugehörige Eingangssignal I₁ den Empfänger 4b zumindest zeitweise übersteuert.

Erfindungsgemäß wird eine Detektionsphase durchgeführt, um aus dem im Arbeitsbereich A liegenden Ausgangssignal I, hier beispielsweise I_{A}, die Verlagerung X mehrfach zu ermitteln, wobei der weitere Parameter R einen im Wesentlichen konstanten Wert einnimmt. Der Arbeitsbereich A zeichnet sich dadurch aus, dass das Ausgangssignal O, hier O_{A}, eindeutig einem Eingangssignal I_{A} und damit einer zugehörigen Verlagerung X über den gesamten Arbeitsbereich A zugeordnet werden kann.

Erfindungsgemäß werden nunmehr wenigstens eine erste und zweite Testphase durchgeführt, bei der der weitere Parameter R gegenüber dem zuvor erwähnten konstanten Wert so verändert ist oder wird, dass das Eingangssignal I der Testphase, hier I₁ und I₂, in einem außerhalb des Arbeitsbereichs A liegenden Ausgangssignal O, hier O₁ und O₂, resultieren. Die resultierenden Ausgangssignale O, hier O₁ und O₂, werden durch die Auswerteinheit 5 dahingehend ausgewertet, ob die Funktion des Senders 4a und/oder die Funktion des Empfängers 4b gewährleistet ist. Beispielsweise werden die Ausgangsignale O, hier O₁ und O₂, jeweils mit einem zu erwartenden vorgespeicherten Vergleichswert verglichen und bei Überschreiten einer vorgegebenen Maximalabweichung, eine Fehlfunktion des Senders und/oder Empfängers an eine übergeordnete Steuereinheit gemeldet, welche in Folge beispielsweise den autonomen Fahrbetrieb unterbricht oder verweigert.

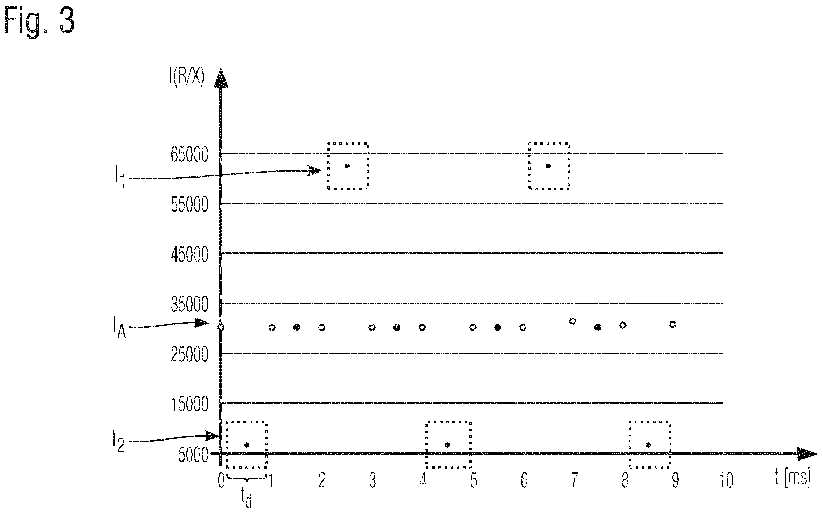

Da die Auswerteinheit 5 dabei ausgelegt ist, erst nach einer Fehlertoleranzdauer auf ein dem Arbeitsbereich A nicht zuordenbares Ausgangssignal mit einer Fehlerausgabe oder einem Fehlerzustand zu reagieren, fällt die jeweilige Testphase in die Fehlertoleranzdauer, d.h. die Dauer der Testphase ist kürzer als due Fehlertoleranzdauer, wie es beispielsweise in der später erläuterten Figur 3 gezeigt ist. Dadurch ist es nicht erforderlich, die Detektionsphase für die Testphase zu unterbrechen und letztere kann in eine fortlaufende Detektion leichter integriert werden, ohne dass es lediglich aufgrund eines außerhalb des Arbeitsbereichs liegenden Ausgangssignals zu einer Störung kommt. Beispielsweise beträgt die Fehlertoleranzdauer 10ms oder weniger.

Wie in Figur 2 gezeigt sind zwei Testphasen vorgesehen, die sich im Wert des jeweiligen weiteren Parameters R unterscheiden, wobei die weiteren Parameter R so gewählt sind, dass eine in der jeweiligen Testphase maximal mögliche, ausschließlich durch die Verlagerung X bewirkte Variation des Ausgangssignals O jeweils einen ersten Testbereich T₁ und einen zweiten Testbereich T₂ definiert, der sich jeweils nicht mit dem Arbeitsbereich A überschneidet. Genauer wird in der jeweiligen Testphase durch geeignete Wahl des weiteren Parameters R das zugehörige Eingangssignal I, hier I₁ bzw. I₂, jeweils so eingestellt, dass eine ausschließlich durch die Verlagerung X bewirkte, den jeweiligen Testbereich T₁ bzw. T₂ definierende Variation des zugehörigen Ausgangssignals O, hier O₁ bzw. O₂, geringer ausfällt als eine Breite des Arbeitsbereichs A, wodurch die Verlagerung X geringere Auswirkung auf die Funktionsüberprüfung in der Testphase hat.

Der weitere Parameter R, hier als R₁ bezeichnet, ist in der ersten Testphase T₁ so gewählt, dass das zugehörige Eingangssignal I, hier I₁ den Empfänger 4b in der ersten Testphase T₁ zumindest zeitweise übersteuert. Dadurch kann die Zuverlässigkeit der Funktionsüberprüfung gewährleistet werden. Ferner kann das charakteristische Verhalten des Empfängers 4b in dessen "Sättigungsbetrieb" zur Funktionsüberprüfung herangezogen werden. Das dem zweiten Testbereich T₂ zugeordnete Eingangssignal I₂ ist durch Wahl des weiteren Parameters R, hier R₂, so eingestellt, dass der Empfänger 4b in einer "Anlaufphase" arbeitet, in der das Ausgangssignal O dem Eingangssignal I unterproportional folgt.

Figur 3 zeigt die zeitliche Abfolge des Eingangssignals I. Zwischen einer Abfolge von drei dem Arbeitsbereich A zugehörigen Messungen mit dem Eingangssignal I_{A} wird bei konstant gehaltenem weitern Parameter R die Verlagerung X anhand der Variation des zugehörigen Ausgangssignal O_{A} ermittelt. Zwischen drei Messungen einer Detektionsphase erfolgt, in der jeweiligen intermediären Testphase, die Funktionsüberprüfung des Senders 4a und/oder Empfängers 4b, bei dem durch Veränderung des weiteren Parameters R das Eingangssignal I gegenüber dem Eingangssignal I_{A} des Arbeitsbereichs A auf das mit I₁ bezeichnete Niveau gehoben wird, so dass das zugehörige Ausgangssignal O in den in Figur 2 gezeigten, ersten Testbereich T₁ fällt und beispielsweise je nach Verlagerung X einem entsprechen Wert O₁ entspricht. In der nachfolgenden zweiten Testphase erfolgt eine weitere Funktionsüberprüfung des Senders 4a und/oder Empfängers 4b, bei der durch Veränderung des weiteren Parameters R das Eingangssignal I gegenüber dem Eingangssignals I_{A} des Arbeitsbereichs A auf das mit I₂ bezeichnete Niveau gehoben wird, so dass das zugehörige Ausgangssignal O in den in Figur 2 gezeigten, ersten Testbereich T₁ fällt und beispielsweise je nach Verlagerung X einem entsprechen Wert O₁ entspricht. Die erste und zweite Testphase werden im Folgenden zeitlichen Verlauf periodisch wiederholt.

## Patentansprüche

1. Bedienelement (1), aufweisend
einen Träger (2);
ein am Träger (2) elastisch rückstellend und beweglich gelagertes und/oder am Träger (2) elastisch verformbar abgestütztes Betätigungsteil (3), welches eine einem Bediener (B) zugewandte Betätigungsfläche (10) aufweist, und um eine Verlagerung (X) der Betätigungsfläche (10) entgegen einer Rückstellkraft relativ zum Träger (2) bei Einwirken einer Betätigungskraft auf die Betätigungsfläche (10) zu ermöglichen;
eine Detektionseinrichtung (4) zur Detektion der Verlagerung (X), die einen Sender (4a) und einen Empfänger (4b) aufweist, wobei der Sender (4a) ein am Empfänger (4b) anliegendes, mit der Verlagerung (X) variierendes Eingangssignal (I) erzeugt, wobei der Empfänger (4b) aus dem Eingangssignal (I) ein Ausgangssignal (O) erzeugt, wobei das Eingangssignal (I) ferner durch einen von der Verlagerung (X) unabhängigen, weiteren Parameter (R) variiert werden kann, wobei zumindest über einen Arbeitsbereich (A) des Ausgangssignals (O) bei konstantem weiterem Parameter (R) dem Ausgangssignal (O) eine Verlagerung (X) eindeutig zugeordnet werden kann;
eine Auswerteinheit (5), die ausgebildet ist, in einer Detektionsphase bei einem im Wesentlichen konstanten Wert des weiteren Parameters (R) aus dem im Arbeitsbereich (A) liegenden Ausgangssignal (O) die Verlagerung (X) mehrfach zu ermitteln und in wenigstens einer Testphase, bei der der weitere Parameter (R) gegenüber dem konstanten Wert so verändert ist oder wird, dass das Eingangssignal (I) der Testphase in einem außerhalb des Arbeitsbereichs (A) liegenden Ausgangssignal (O) resultiert, das resultierende Ausgangssignal (O) dahingehend auszuwerten, ob die Funktion des Senders (4a) und/oder die Funktion des Empfängers (4b) gewährleistet ist.

2. Bedienelement (1) nach dem vorhergehenden Anspruch, wobei die Auswerteinheit (10) ausgelegt ist, erst nach einer Fehlertoleranzdauer (t_{d}) auf ein dem Arbeitsbereich (A) nicht zuordenbares Ausgangssignal (O) mit einer Fehlerausgabe oder einem Fehlerzustand zu reagieren, und die Testphase in die Fehlertoleranzdauer (t_{d}) fällt.

3. Bedienelement (1) nach dem vorhergehenden Anspruch, wobei die Fehlertoleranzdauer (t_{d}) 10ms oder weniger, bevorzugt 5ms oder weniger, beträgt.

4. Bedienelement (1) nach einem der vorhergehenden Ansprüche, wobei in der Testphase durch geeignete Wahl des weiteren Parameters (R) das zugehörige Eingangssignal (I) so eingestellt ist, dass eine ausschließlich durch die Verlagerung (X) bewirkte Variationsbreite des zugehörigen Ausgangssignals (O) geringer ausfällt als die des Arbeitsbereichs (A).

5. Bedienelement (1) nach einem der vorhergehenden Ansprüche, wobei der weitere Parameter (R) in der Testphase so gewählt ist, dass das zugehörige Eingangssignal (I) den Empfänger (4b) zumindest zeitweise übersteuert.

6. Bedienelement (1) nach einem der vorhergehenden Ansprüche, wobei der weitere Parameter (R) in der Testphase zeitlich variiert wird, und die Auswerteinheit (5) ausgelegt ist, anhand der der zeitlichen Variation des weiteren Parameters (R) folgenden Variation des Ausgangssignals (O) die Funktion des Senders (4a) und/oder die Funktion des Empfängers (4b) zu überprüfen.

7. Bedienelement (1) nach einem der vorhergehenden Ansprüche, wobei mehrere Testphasen vorgesehen, die sich im Wert des jeweiligen weiteren Parameters (R) unterscheiden.

8. Bedienelement (1) nach einem der vorhergehenden Ansprüche, wobei der oder die weiteren Parameter so gewählt sind, dass eine in der Testphase maximal mögliche, bevorzugt ausschließlich durch die Verlagerung (X) bewirkte, Variation des Ausgangssignals (O) jeweils einen Testbereich (T₁, T₂) definiert, der sich nicht mit dem Arbeitsbereich (A) überschneidet.

9. Bedienelement (1) nach dem vorhergehenden Anspruch, wobei der Arbeitsbereich (A) zwischen zwei Testbereichen (T₁, T₂) liegt.

10. Bedienelement (1) nach dem vorhergehenden Anspruch, wobei die Testphase periodisch wiederholt wird.

11. Bedienelement (1) nach dem vorhergehenden Anspruch, wobei der Sender (4a) eine Lichtquelle und der Empfänger (4b) eine Fotodiode ist.

12. Verwendung des Bedienelements (1) in einem Kraftfahrzeug, insbesondere als ein am Lenkrad angeordnetes Bedienelement (1).

13. Verfahren zur Funktionsüberprüfung eines Bedienelements (1), mit den folgenden Schritten:
Bereitstellen des Bedienelements (1), aufweisend einen Träger (2); ein am Träger (2) elastisch rückstellend und beweglich gelagertes und/oder am Träger elastisch verformbar abgestütztes Betätigungsteil (3), welches eine einem Bediener (B) zugewandte Betätigungsfläche (10) aufweist um eine Verlagerung (X) der Betätigungsfläche (10) entgegen einer Rückstellkraft relativ zum Träger (2) bei Einwirken einer Betätigungskraft auf die Betätigungsfläche (10) zu ermöglichen; eine Detektionseinrichtung (4) zur Detektion der Verlagerung (X), die einen Sender (4a) und einen Empfänger (4b) aufweist, wobei der Sender (4a) ein am Empfänger (4b) anliegendes, mit der Verlagerung (X) variierendes Eingangssignal (I) erzeugt, wobei der Empfänger (4b) aus dem Eingangssignal (I) ein Ausgangssignal (O) erzeugt, wobei das Eingangssignal (I) ferner durch einen von der Verlagerung (X) unabhängigen, weiteren Parameter (R) variiert werden kann, wobei zumindest über einen Arbeitsbereich (A) des Ausgangssignals (O) bei konstantem weiteren Parameter (R) dem Ausgangssignal (O) eine Verlagerung (X) eindeutig zugeordnet werden kann; sowie eine Auswerteinheit (5);
Durchführen einer Detektionsphase, wobei die Auswerteinheit (5) bei dem auf einem im Wesentlichen konstanten Wert liegenden, weiteren Parameter (R) aus dem im Arbeitsbereich (A) liegenden Ausgangssignals (O) die Verlagerung (X) mehrfach ermittelt;
Durchführen wenigstens einer Testphase, bei der der weitere Parameter (R) so gegenüber dem konstanten Wert verändert ist oder wird, dass das Eingangssignal (I) der Testphase in einem außerhalb des Arbeitsbereichs (A) liegenden Ausgangssignal (O) resultiert, und durch die Auswerteinheit (5) das resultierende Ausgangssignal (O) dahingehend ausgewertet wird, ob die Funktion des Senders (4a) und/oder die Funktion des Empfängers (4b) gewährleistet ist.

14. Verfahren nach dem vorhergehenden Anspruch, wobei die Auswerteinheit (5) ausgelegt ist, erst nach einer Fehlertoleranzdauer (t_{d}) auf ein dem Arbeitsbereich (A) nicht zuordenbares Ausgangssignal (O) mit einer Fehlerausgabe oder einem Fehlerzustand zu reagieren, und die Testphase in die Fehlertoleranzdauer (t_{d}) fällt.

15. Verfahren nach dem vorhergehenden Anspruch, wobei die Fehlertoleranzdauer (t_{d}) 10ms oder weniger, bevorzugt 5ms oder weniger, beträgt.

16. Verfahren nach einem der vorhergehenden Ansprüche 13 bis 15, wobei in der Testphase durch geeignete Wahl des weiteren Parameters (R) das zugehörige Eingangssignal (I) so eingestellt ist, dass eine ausschließlich durch die Verlagerung (X) bewirkte Variationsbreite des zugehörigen Ausgangssignals (O) geringer ausfällt als die des Arbeitsbereichs (A).

17. Verfahren nach einem der vorhergehenden Ansprüche 13 bis 16, wobei der weitere Parameter in der Testphase so gewählt ist, dass das zugehörige Eingangssignal den Empfänger zumindest zeitweise übersteuert.

18. Verfahren nach einem der vorhergehenden Ansprüche 13 bis 17, wobei der weitere Parameter (R) in der Testphase zeitlich variiert wird, und die Auswerteinheit (5) ausgelegt ist, anhand der der zeitlichen Variation des weiteren Parameters (R) folgenden Variation des Ausgangssignals (O) die Funktion des Senders (4a) und/oder die Funktion des Empfängers (4b) zu überprüfen.

19. Verfahren nach einem der vorhergehenden Ansprüche 13 bis 18, wobei mehrere Testphasen durchgeführt werden, die sich jeweils im Wert des weiteren Parameters (R) unterscheiden.

20. Verfahren nach einem der vorhergehenden Ansprüche 13 bis 19, wobei der oder die weiteren Parameter so gewählt sind, dass eine in der Testphase maximal mögliche, bevorzugt ausschließlich durch die Verlagerung (X) bewirkte, Variation des Ausgangssignals (O) jeweils einen Testbereich (T₁, T₂) definiert, der sich nicht mit dem Arbeitsbereich (A) überschneidet.

21. Verfahren nach dem vorhergehenden Anspruch, wobei der Arbeitsbereich zwischen zwei Testbereichen (T₁, T₂) liegt.

22. Verfahren nach einem der vorhergehenden Ansprüche 13 bis 21, wobei die Testphase periodisch wiederholt durchgeführt wird.
